# EUROPÄISCHE PATENTSCHRIFT

(11) **EP 0 840 445 B1**
(45) Veröffentlichungstag und Bekanntmachung des Hinweises auf die Patenterteilung: **09.02.2005**
(21) Anmeldenummer: 97203355.9
(22) Anmeldetag: 29.10.1997
(51) Int. Cl.: H03G 3/30, H03G 1/00

(54) **Schaltungsanordnung zur Hochfrequenzpegelregelung**
Circuit for controlling the level of a radio frequency signal
Circuit de réglage de niveau d'un signal radiofréquence

(30) Priorität: 05.11.1996 DE 19645508
(43) Veröffentlichungstag der Anmeldung: 06.05.1998
(73) Patentinhaber: Philips Intellectual Property & Standards GmbH, 20099 Hamburg (DE); Koninklijke Philips Electronics N.V., 5621 BA Eindhoven (NL)
(72) Erfinder: Birth, Winfrid, Dipl.-Ing., Röntgenstrasse 24, 22335 Hamburg (DE)
(74) Vertreter: Volmer, Georg, Dipl.-Ing.

(56) Entgegenhaltungen:
- EP-A- 0 524 806
- EP-A- 0 565 299
- EP-A- 0 696 847
- WO-A-96/23365
- US-A- 5 151 625
- R.-CH. HOUZE: "Le générateur B.F. à phase variable VPO 602 FEEDBACK" TOUTE L'ELECTRONIQUE., Bd. 06, Nr. 433, Juni 1978 (1978-06), Seiten 65-71, XP002155194 SOCIETE DES EDITIONS RADIO. PARIS., FR

## Beschreibung

Die Erfindung betrifft eine Schaltungsanordnung zur Hochfrequenzpegelregelung mit einem Pegelstellglied zur Bildung eines Ausgangssignals mittels Mischung eines Eingangssignals und eines Rückkopplungssignals in einer Gilbert-Zelle, einem Sensor in einem Rückkopplungszweig zur Bildung eines Meßsignals und eines Referenzsignals aus dem Ausgangssignal und einem Regelverstärker im Rückkopplungszweig zur Bildung des Rückkopplungssignals aus der Differenz zwischen Meß- und Referenzsignal.

Aus 1995 IEEE International Solid State Circuits Conference (ISSCC95), Session 8, Wireless Communications, Paper TA 8.7, Seiten 148, 149, 354, 112, 113, 312 ist ein GSM Transceiver IC mit On-Chip-Filter bekannt. Dabei ist beschrieben, das IF-Transmissionssignal in einer Hochfrequenzschaltungsanordnung auf einen Pegel von 50 mV zu regeln, indem mittels eines Verstärkers die Hochfrequenzmischer in ihrem maximalen linearen Bereich betrieben werden.

Aus DE 43 38 721 A1 ist ein Mehrbandfunkgerät bekannt, das einen Mischer in einem Mehrbandempfanger enthält. Dieser Mischer ist für eine Zwischenfrequenzumsetzung mittels einer Mischfrequenz vorgesehen, wobei alternativ auch ein Gilbertzellen-Mischer verwendet werden kann (Spalte 3, Zeile 52 - 56). Gegenüber einem Ringmischer, der bei entsprechender Mischersymmetrie schon eine ausreichende Dämpfung von unerwünschten Nebenempfangsstellen innerhalb des Empfangsbandes ermöglicht, kann der Gilbertzellen-Mischer integriert werden.

Aus EP 0 696 847 A2 ist eine Schaltungsanordnung zur Umwandlung einer Spannung in einen Strom bekannt, der geeignet ist, mittels eines Stromspiegels ein Eingangsspannungssignal in ein Paar komplementärer Stromsignale umzuwandeln, Die Ausgangsstromsignale des Konverters werden dabei einer Gilbert-Zelle zugeführt, wobei die Gilbert-Zelle zwei Stromspiegelanordnungen enthält.

Besonders bei Batterie- oder Akku-betriebenen Geräten (beispielsweise Handgeräte für den Mobilfunk) ist es interessant, die Versorgungsspannung zur Minderung des Energieverbrauchs oder anderen aus gerätespezifischen Gründen zu reduzieren, wodurch im Betrieb des Gilbert-Zellen-Mischers nach dem Stand der Technik Probleme auftreten können.

Die Aufgabe der Erfindung ist es daher, eine Schaltungsanordnung zu schaffen, die den Betrieb einer Gilbert-Zelle als Hochfrequenzmischer bei geringer Versorgungsspannung gewährleistet.

Diese Aufgabe wird bei der erfindungsgemäßen Schaltungsanordnung dadurch gelöst, daß in der Gilbert-Zelle zwischen einer mit dem Rückkopplungssignal gekoppelten ersten Stufe und einer mit dem Eingangssignal gekoppelten zweiten Stufe wenigstens eine Stromspiegelanordnung vorgesehen ist. Eine Gilbert-Zelle besteht in der Regel aus zwei gekoppelten Stufen und arbeitet als Vierquadrantenmultiplizierer. Die zweite (oder obere) Stufe wird dabei aus zwei symmetrischen Differenzverstärkern gebildet, mit deren kreuzweise verschalteten Basisanschlüssen beispielsweise das hochfrequente Eingangssignal gekoppelt ist. Die paarweise gekoppelten Emitteranschlüsse der Differenzverstärker sind jeweils mit einem Kollektoranschluß eines der beiden Transistoren der ersten (oder unteren) Stufe verbunden. An deren Basisanschlüssen liegen das Rückkopplungssignal und das invertierte Rückkopplungssignal. Die beiden Transistoren der ersten Stufe bilden so einen Differenzverstärker mit Stromgegenkopplung. Dabei stellen die Kollektoren die Ausgänge von zwei Stromquellen dar, die durch o. a. Kopplung vom Rückkopplungssignal gegensinnig gesteuert werden. Bei der erfindungsgemäßen Schaltungsanordnung zur Hochfrequenzpegelregelung sollen das aus dem Ausgangssignal gebildete Rückkopplungssignal und das Eingangssignal gemischt werden, die dafür jeweils an eine der beiden Stufen der Gilbert-Zelle angekoppelt werden. Zwischen diesen Stufen ist erfindungsgemäß wenigstens eine Stromspiegelanordnung vorgesehen, mit deren Hilfe der Strom aus der unteren Stufe in die obere Stufe hineingespiegelt wird. Die beiden ...

Transistoren der ersten Stufe sind dabei jeweils über eine Stromspiegelanordnung mit einem der beiden symmetrischen Differenzverstärker der zweiten Stufe verbunden. Dadurch kann die Gilbert-Zelle bei einer geringeren Versorgungsspannung betrieben werden. Durch eine Parallelschaltung von entsprechend vielen Transistoren im Ausgangszweig des Stromspiegels lassen sich ganzzahlige Vielfache des Eingangsstromes erzeugen. Durch geeignete Wahl des Übersetzungsverhältnisses kann eine Stromeinsparung erzielt werden.

In einer bevorzugten Ausgestaltung der Erfindung besteht die Stromspiegelanordnung aus wenigstens zwei in Serie geschalteten symmetrischen Stromspiegeln. Die Verwendung von zwei aufeinanderfolgenden Stromspiegeln in Reihenschaltung ermöglicht mehr einstellbare Spiegelfaktoren und insbesondere auch größere Übersetzungsverhältnisse.

Bei einer weiteren Ausführungsform ist in der Stromspiegelanordnung ein erster Stromspiegel bestehend aus wenigstens zwei pnp-Bipolartransistoren und ein zweiter Stromspiegel bestehend aus wenigstens zwei npn-Bipolartransistoren vorgesehen. Neben den angegebenen Bauformen für die Halbleiterbauelemente in den Stromspiegeln ist auch der Einsatz anderer Bauelemente, wie zum Beispiel Feldeffekttransistoren, denkbar.

Für eine vorteilhafte Weiterbildung der Erfindung ist zur Regelung des ersten Stromspiegels ein Kollektoranschluß und ein Basisanschluß eines ersten Regeltransistors zur Kopplung mit dem Eingangssignal des Stromspiegels und ein Emitteranschluß des ersten Regeltransistors zur Kopplung mit einer konstanten Stromquelle und ein Basisanschluß eines zweiten Regeltransistors zur Kopplung mit dem Eingangssignal, ein Kollektoranschluß des zweiten Regeltransistors zur Kopplung mit einer Versorgungsspannung und ein Emitteranschluß des zweiten Regeltransistors zur Kopplung mit der konstanten Stromquelle vorgesehen.

In einer möglichen Ausgestaltung der erfindungsgemäßen Schaltungsanordnung ist im Sensor ein mittels eines Spannungsteilers erzeugter Teil des Ausgangssignals zur Bildung des Meßsignals und des Referenzsignals vorgesehen. Auf diese Weise kann der Sensor für beliebige Spannungspegel des Ausgangssignals verwendet werden. Durch entsprechende Dimensionierung der Bauelemente des Spannungsteilers wird bei einem erhöhten Ausgangssignalspannungspegel ein für den Sensor geeigneter Pegel erzeugt. Ein Spannungsteiler läßt sich in besonders geeigneter Weise integrieren, jedoch sind auch andere Formen der Spannungstransformation denkbar.

Weiterhin betrifft die Erfindung noch ein Mobilfunkgerät mit einer erfmdungsgemäßen Schaltungsanordnung zur Hochfrequenzpegelregelung und eine Schaltungsanordnung zur Mischung zweier Eingangssignale.

Nachfolgend soll ein mögliches Ausführungsbeispiel der Erfindung anhand von Zeichnungen erläutert werden. Dabei stellen
- Figur 1:: ein vereinfachtes Blockschaltbild eines allgemeinen Regelkreises mit Rückkopplungszweig,
- Figur 2:: eine Schaltskizze der schaltungstechnischen Realisierung eines Pegelstellgliedes aus dem Regelkreis,
- Figur 3:: eine Schaltskizze der schaltungstechnischen Realisierung eines Regelverstärkers des Regelkreises,
- Figur 4:: eine Schaltskizze der schaltungstechnischen Realisierung eines Sensors des Regelkreises und
- Figur 5:: eine Schaltskizze der schaltungstechnischen Realisierung eines Sensors des Regelkreises mit einem Spannungsteiler zur Anpassung der Amplitude des Zwischenfrequenzsignals IF1
dar.

Im dargestellten Ausführungsbeispiel wird die Hochfrequenzpegelregelung als Zwischenfrequenz-(IF)-Verstärker im Sendepfad eines Mobilfunkendgerätes nach dem GSM-Standard eingesetzt. Das Ausgangssignal ist ein in seiner Amplitude geregeltes Zwischenfrequenzsignal IF1 bzw. invertiertes Zwischenfrequenzsignal IF1X. Die Schaltungsanordnungen sind weitesgehend symmetrisch für das jeweilige Signal und das dazu invertierte Signal, so daß im folgenden entsprechend analoge Beschreibungen für den Schaltungsteil für das jeweils mit einem 'X' am Ende gekennzeichnete, invertierte Signal gelten. Faktorisierungsziffern an den eingezeichneten Bauelementen kennzeichnen eine Parallelschaltung der angegebenen Anzahl von gleichen Bauelementen. Dabei entstehen insbesondere bei Stromspiegeln spezielle Übersetzungsfaktoren für das Verhältnis von Eingangsstrom auf der Primärseite zu Ausgangsstrom auf der Sekundärseite.

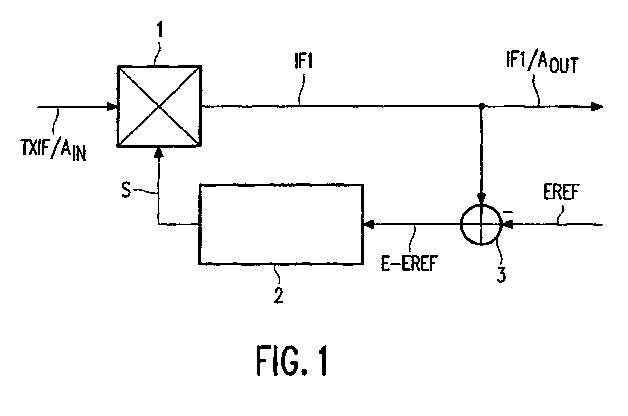

In Figur 1 ist ein schematisches Blockschaltbild eines Regelkreises angegeben, der sowohl in Hochfrequenzpegelreglern in Rundfunkempfängern als auch in Mobilfunkgeräten verwendet werden kann. Er wird gebildet aus einem Pegelstellglied 1, einem Regelverstärker 2, in den oft ein Filter integriert ist, und einem Sensor 3. Ein Ausgangssignal A_{OUT} soll in seiner Amplitude auf ein Referenzsignal geregelt werden. Dabei gilt als Randbedingung, daß bei einem möglichst konstanten Pegel für das sinusförmige, hochfrequente Ausgangssignal A_{OUT} der Pegel eines Eingangssignals A_{IN} in weiten Grenzen variieren kann. Das Ausgangssignal, hier IF1/IF1X, wird rückgekoppelt und dem Sensor 3 zugeführt. Im Sensor 3 wird aus dem IF1/IF1X-Signals ein Meßsignal E und ein Referenzsignal EREF gebildet und dem Regelverstärker 2 zugeführt. Im Regelverstärker 2 wird durch Verstärkung und Filterung aus der Differenz des Meßsignals und des Referenzsignals E-EREF ein Rückkopplungssignal S, bzw. ein invertiertes Rückkopplungssignal SX, erzeugt. Dieses Rückkopplungssignal S/SX wird über das Pegelstellglied 1 in die Regelstrecke zurückgekoppelt. Im Pegelstellglied 1 wird zur Regelung des Ausgangssignals IF1/IF1X auf eine bestimmte Amplitude das Rückkopplungssignal S/SX in einer Gilbert-Zelle mit einem symmetrischen Hochfrequenz-Eingangssignal, hier ein ungeregeltes, in seiner Amplitude variierendes Zwischenfrequenzsignal TXIF/TXIFX, gemischt. Die detaillierten Ausführungen des Pegelstellgliedes 1, des Regelverstärkers 2 und des Sensors 3 werden nachfolgend anhand der Figuren erläutert.

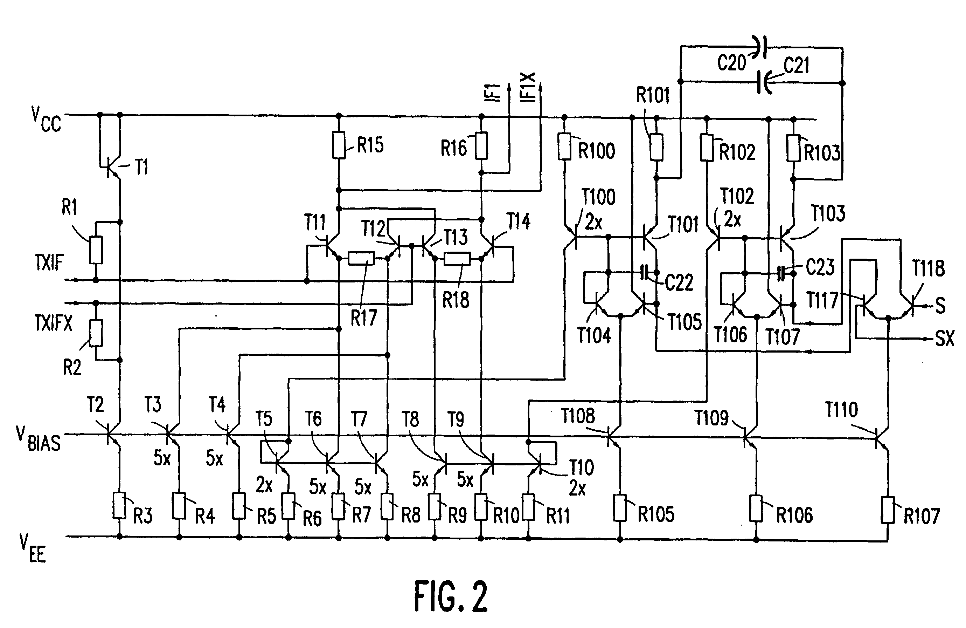

In Figur 2 zeigt die schaltungstechnische Realisierung des Pegelstellgliedes 1. Das ungeregelte Zwischenfrequenzsignal TXIF/TXIFX und das Rückkopplungssignal S/SX werden zugeführt und daraus das Ausgangssignal IF1/IF1X erzeugt. S und SX liegen je an einem Basisanschluß zweier npn-Transistoren T118 und T117, deren Emitteranschlüsse mit einem Kollektoranschluß eines npn-Transistors T110 gekoppelt sind. Diese beiden Transistoren bilden die untere Stufe einer Gilbert-Zelle, die als Mischer für die hochfrequenten Signale verwendet wird. Der Basisanschluß des Transistors T110 ist mit einer Referenzspannungsquelle V_{BIAS} verbunden, die von einer Band-gap-Referenz erzeugt wird und in üblicher Weise Konstantstromquellen, wie zum Beispiel Transistor T110, steuert. Der Emitteranschluß von Transistor T110 liegt über einen Widerstand R107 an einer Bezugsspannung V_{EE} = 0V. Im weiteren wird nur der Verlauf des Signals S beschrieben, da für das symmetrische Signal SX ein analoger Schaltungsteil in der Figur 2 dargestellt ist. Der Kollektoranschluß des Transistors T118 ist sowohl mit dem Kollektoranschluß eines pnp-Transistors T103 als auch über einen Kondensator C23 mit den Basisanschlüssen des Transistors T103 und eines pnp-Transistors T102 verbunden. Die Emitteranschlüsse der Transistoren T103 und T102 sind jeweils über einen Widerstand R103 bzw. R102 mit einer Versorgungsspannung V_{CC} gekoppelt, die bei der Ausführungsform im Bereich von 2,7V bis 5,5V liegen kann. Daher arbeiten die beiden pnp-Transistoren T103 und T102 als Stromspiegel, der das Signal S am Kollektoranschluß von Transistor T102 zur Verfügung stellt. Dieser Stromspiegel ist mit einer speziellen Regelung versehen, die von den npn-Transistoren T106 und T107 gebildet wird. Deren gekoppelte Emitteranschlüsse sind über die Kollektor-Emitter-Strecke eines, wie Transistor T110 als Konstantstromquelle arbeitenden, npn-Transistors T109 und einen Widerstand R106 mit V_{EE} verbunden. Das Signal S läuft über den Basisanschluß des Transistors T107 und ist über den Kondensator C23 mit dem Basis- und dem Kollektoranschluß des Transistors T106 gekoppelt. Der Kollektoranschluß des Transistors T107 ist mit der Versorgungsspannung V_{CC} verbunden. Für das Signal SX ist symmetrisch zum beschriebenen Teil eine entsprechende Schaltung eingefügt. Die Regelung der pnp-Stromspiegel durch jeweils ein npn-Transistorpaar ermöglicht die Verwendung einer geringeren Versorgungsspannung (beispielsweise V_{CC} = 2,7V). Zur Optimierung des Gesamtschleifenfrequnzgangs und zur lokalen Stabilisierung werden Kondensatoren C20 und C21 eingefügt. Hier werden die Emitteranschlüsse der Primärseiten der jeweiligen Stromspiegel für die Signale S und SX über C20 und C21 miteinander gekoppelt. Aufgrund der parasitären Substratkapazitäten liegen C20 und C21 antiparallel. Dadurch wird eine erhöhte Symmetrie erreicht. Alternativ zu der dargestellten Lösung kann der Widerstand R103, bzw. R101 für das Signal SX, zwischen V_{CC} und Emitteranschluß auch mit jeweils einem Kondensator überbrückt werden. In diesem Fall sind die Kapazitätswerte für die Kondensatoren jeweils zu verdoppeln. Zur Optimierung des Betriebes im Arbeitspunkt dienen ebenfalls die Kondensatoren C23 bzw. C22.

An diese geregelten ersten pnp-Stromspiegel ist jeweils für das Signal S und SX ein zweiter npn-Stromspiegel gekoppelt. Dazu ist die Sekundärseite des ersten Stromspiegels, d. h. der Kollektoranschluß des Transistors T102, sowohl mit dem Basisund Kollektoranschluß eines npn-Transistors T10 als auch mit den Basisanschlüssen der npn-Transistoren T8 und T9 verbunden. Die Emitteranschlüsse der Transistoren T10, T8 und T9 sind über Widerstände R11 sowie R9 und R10 mit V_{EE} gekoppelt. Auf die gleiche Weise ist die Sekundärseite des entsprechenden Schaltungsteils für das invertierte Signal SX mit einem zweiten Stromspiegel aus npn-Transistoren T5, T6 und T7 verbunden. Deren Emitteranschlüsse sind über Widerstände R6, R7 und R8 mit V_{EE} verbunden. Die Kollektoranschlüsse der Transistoren der Sekundärseite des zweiten Stromspiegels sind mit der oberen Stufe der Gilbert-Zelle gekoppelt. Insgesamt ermöglicht diese Reihenschaltung von jeweils zwei symmetrischen Stromspiegeln die Reduzierung der Versorgungsspannung V_{CC} auf bis zu 2,7V. Die pnp-Stromspiegel wie auch die npn-Stromspiegel besitzen zur Stromeinsparung, zum Beispiel durch Parallelschaltung von mehreren Transistoren auf der Sekundärseite, entsprechende Übersetzungsfaktoren.

Die obere Stufe der Gilbert-Zelle besteht aus zwei npn-Transistorpaaren T11 und T12 sowie T13 und T14. Im Pfad für das Signal S sind die Kollektoranschlüsse der Transistoren T8 und T9 mit den Emitteranschlüssen der Transistoren T13 und T14 verbunden. Diese sind untereinander noch über einen Widerstand R18 gekoppelt. Entsprechend sind im Pfad für das invertierte Signal SX die Transistoren T6 und T7 mit den Transistoren T11 und T12 und über einen Widerstand R17 gekoppelt. Das Eingangssignal TXIF liegt an den Basisanschlüssen der Transistoren T14 und T11 und das invertierte Eingangssignal TXIFX an den Basisanschlüssen der Transistoren T12 und T13. Die Kollektoranschlüsse der Transistorpaare sind ebenfalls kreuzweise verschaltet, wobei an den gekoppelten Kollektoranschlüssen der Transistoren T12 und T14 das Ausgangssignal IF1 sowie an den gekoppelten Kollekoranschlüssen der Transistoren T11 und T13 das invertierte Ausgangssignal IF1X abgegriffen wird. Diese Knoten, an denen das Ausgangssignal IF1 und IF1X abgegriffen wird, sind über Widerstände R16 bzw. R15 mit V_{CC} verbunden. Der Pegel des Eingangssignals kann dabei im Bereich von 50 bis 250 mV variieren. Das Eingangssignal TXIF/TXIFX ist über einen Widerstand R1 bzw. R2 mit dem Emitteranschluß eines npn-Transistors T1 gekoppelt. Der Kollektor- und der Basisanschluß von T1 ist mit V_{CC} verbunden. Der Emitteranschluß von T1 ist noch mit dem Kollektoranschluß eines npn-Transistors T2 gekoppelt, dessen Basisanschluß mit V_{BIAS} verbunden ist. Der Emitteranschluß von T2 liegt über einen Widerstand R3 an V_{EE}.

Eine Gilbert-Zelle ist normalerweise ein Vier-Quadranten-Multiplizierer. Die Möglichkeit im Ergebnis beide Vorzeichen bilden zu können, ist bei Anwendung als erfindungsgemäßer Hochfrequenzmischer im Pegelregelkreis nicht notwendig. Für eine Regelung ist es statt dessen erforderlich, daß das Vorzeichen nie wechselt. Aus diesem Grund ist das linke Transistorpaar T11 und T12 der oberen Stufe der Gilbert-Zelle zusätzlich mit npn-Transistoren T3 und T4 gekoppelt. Die Basisanschlüsse dieser Transistoren T3 und T4 sind mit der Referenzspannungsquelle V_{BIAS} verbunden und ihre Emitteranschlüsse liegen über Widerstände R4 und R5 an V_{CC}. Das bedeutet, sie arbeiten als Konstantstromquellen, wobei der Kollektoranschluß des Transistors T3 mit dem Emitteranschluß des Transistors T11 und entsprechend Transistor T4 mit Transistor T12 gekoppelt ist. Dieser zusätzlich abgeführte Strom führt zu einer absichtlichen Schiefstellung der Gilbert-Zelle und damit zu einem unsymmetrischen Multiplizierer, um eine Multiplikation mit Null zu vermeiden. Dazu sind diese Konstantstromquellen T3 und T4 so gut mit der vom Transistor T110 in der unteren Stufe der Gilbert-Zelle gebildeten Konstantstromquelle korreliert, daß auch in einem Toleranzgrenzfall lediglich das Verhalten eines Zwei-Quadranten-Multiplizierers zustande kommt und das Ergebnis 'Null' nicht möglich ist. Am Ausgang des Pegelstellgliedes 1 nach Figur 2 ergibt sich damit das im Pegel geregelte Ausgangssignal IF1 und IF1X, wobei für das Ergebnis das Stromverhältnis vom Transistorpaar T11 und T12 zum Transistorpaar T13 und T14 verantwortlich ist. Im Fall einer Stromgleichheit, der wie oben beschrieben verhindert wird, wäre das Ergebnis aufgrund der kreuzweisen Kopplung der Kollektoranschlüsse gleich 'Null'.

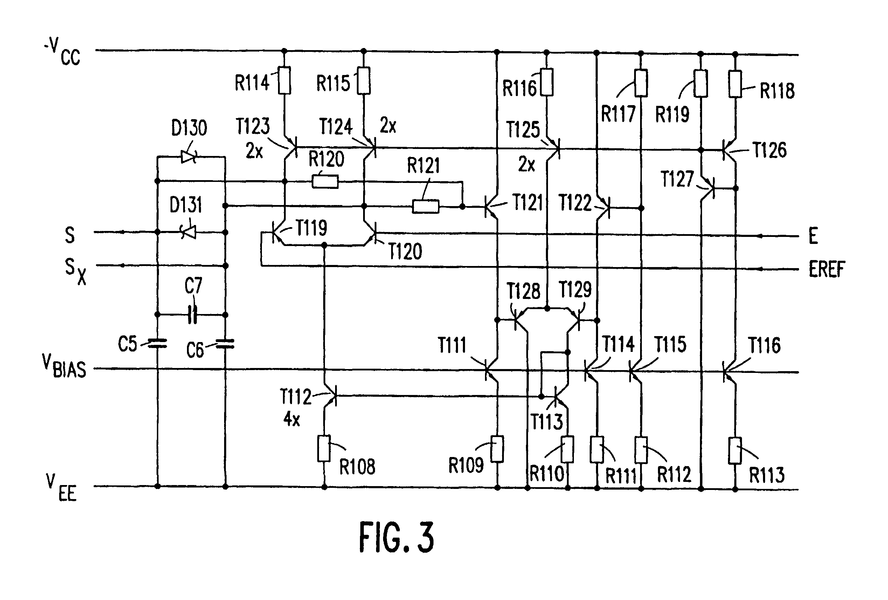

In Figur 3 ist die Schaltung für einen Regelverstärker 2 des beschriebenen Ausführungsbeispiels der Erfindung dargestellt. Im Regelverstärker 2 wird die eingehende Differenz aus Meßsignal E und Referenzsignal EREF einem einstufigen Regelverstärker bestehend aus npn-Transistoren T119 und T120 zugeführt. Das Meßsignal E wird dazu mit dem Basisanschluß von T120 und das Referenzsignal EREF mit dem Basisanschluß von T119 gekoppelt. Die Ausgänge des Regelverstärkers 2 liefern das Rückkopplungssignal S/SX, wobei die Kollektoranschlüsse von T120/T119 mit den Basisanschlüssen von T117/T118 aus Figur 2 verbunden sind, die die untere Stufe der oben beschriebenen Gilbert-Zelle im Pegelstellglied 1 bilden. Als Quellenspannungen stehen wieder die Versorgungsspannung V_{CC} und die Referenzspannung V_{BIAS} zur Verfügung. Ein npn-Transistor T116 ist am Basisanschluß mit der Referenzspannung V_{BIAS} und am Emitteranschluß über einen Widerstand R113 mit der Bezugsspannung V_{EE} gekoppelt. Die so gebildete Konstantstromquelle bestimmt den Strom für den Regelverstärker 2, wobei der Strom über einen Stromspiegel aus pnp-Transistoren T123, T124, T125 und T126 an die Schaltung geliefert wird. Daher ist der Kollektoranschluß des Transistors T116 mit dem Kollektoranschluß des die Primärseite des Stromspiegels bildenden Transistor T126 verbunden. Der Emitteranschluß des Transistors T126 ist über einen Widerstand R118 mit der Versorgungsspannung V_{CC} gekoppelt. Weiterhin ist der Kollektor von T116 nicht direkt mit dem Basisanschluß von T126 gekoppelt, sondern liegt am Basisanschluß eines pnp-Transistors T127. Der Kollektoranschluß von T127 ist mit V_{EE} und der Emitteranschluß mit der Basis von T126 sowie über einen Widerstand R119 mit V_{CC} verbunden. Der Transistor T127 ist somit ein Hilfstransistor, der der Verbesserung der Genauigkeit des Stromspiegels dient. Die Basisanschlüsse der parallelgeschalteten Transistoren T123, T124 und T125 sind mit dem Basisanschluß von T126 gekoppelt und bilden die Sekundärseite des Stromspiegels. Die Emitteranschlüsse sind über Widerstände R114, R115 und R116 mit V_{CC} verbunden. Der Kollektoranschluß von T123 ist mit dem Kollektoranschluß von T119 und der Kollektoranschluß von T124 mit dem Kollektoranschluß von T120 gekoppelt. Die Emitteranschlüsse von T119 und T120 beide mit dem Kollektoranschluß eines npn-Transistors T112 verbunden. Der Kollektoranschluß von T125 ist mit den Emitteranschlüssen der pnp-Transistoren T128 und T129 verbunden, die einen Hilfsregelkreis bilden. Der Kollektoranschluß von T128 liegt an V_{EE}. Der Kollektoranschluß von T129 ist mit dem Kollektor- und dem Basisanschluß eines npn-Transistors T113 gekoppelt, der die Primärseite eines npn-Stromspiegels aus T113 und T112 bildet. Daher ist der Basisanschluß von T112 ebenfalls mit dem Kollektor von T129 gekoppelt. Die Emitteranschlüsse von T113 und T112 liegen über Widerstände R110 und R108 an der Bezugsspannung V_{EE}.

Weiterhin wird ein npn-Transistor T115 als Konstantstromquelle eingesetzt, dessen Basisanschluß mit V_{BIAS} und Emitteranschluß über einen Widerstand R112 mit V_{EE} verbunden ist. Der Kollektoranschluß von T115 liegt über einen Widerstand R117, der aufgrund der Konstantstromquelle einen konstanten Spannungsabfall liefert, an V_{CC}. Auf diese Weise steht am mit dem Kollektoranschluß von T115 gekoppelten Basisanschluß eines npn-Transistors T122 eine konstante Spannung zur Verfügung, die als Referenz verwendet wird. Der Kollektoranschluß von T122 ist mit V_{CC} verbunden. Der Emitteranschluß von T122 ist mit dem Basisanschluß von T129 aus dem Hilfsregelkreis und mit dem Kollektoranschluß eines npn-Transistors T114 gekoppelt. Dieser Transistor T114 arbeitet ebenfalls als Konstantstromquelle, wobei sein Basisanschluß mit V_{BIAS} und sein Kollektoranschluß über einen Widerstand R111 mit V_{EE} verbunden ist. Der Basisanschluß von T128 ist über eine weitere Konstantstromquelle, gebildet durch einen npn-Transistor T111, und über einen Widerstand R109 mit V_{EE} gekoppelt. Außerdem ist der Basisanschluß von T128 noch mit dem Emitteranschluß eines npn-Transistors T121 gekoppelt, dessen Kollektoranschluß an V_{CC} liegt. Der Basisanschluß von T121 ist über einen Widerstand R120 mit dem Kollektoranschluß von T119 und über einen Widerstand R121 mit dem Kollektoranschluß von T120 verbunden. Zwischen den Kollektoranschlüssen von T119 und T120 sind zwei antiparallele Dioden D130 und D131 geschaltet, die die Transistorsättigung im Regelverstärker 2 verhindern. Da die Kollektoranschlüsse von T120 und T119 außerdem mit je einem Basisanschluß der Transistoren T117 und T118 gekoppelt sind, begrenzen die Dioden D130 und D131 auch den Steuerhub in der unteren Stufe der Gilbert-Zelle des Pegelstellgliedes 1. Weiterhin liegt zwischen den Kollektoranschlüssen von T119 und T120, parallel zu den Dioden D130 und D131, ein Kondensator C7, der aus zwei antiparallel geschalteten Kondensatoren besteht. Der Kollektoranschluß von T120 bzw. T119 ist über einen Kondensator C6 bzw. C5 mit V_{EE} verbunden.

Die Kondensatoren C5, C6 und C7 bestimmen maßgeblich den Frequenzgang des Regelkreises, d. h. insbesondere den Abfall bei hohen Frequenzen (sog. roll-off). Die Kondensatoren C5 und C6 dienen der Stabilisierung des Hilfsregelkreises aus T128 und T129. Der Hilfsregelkreis ist erforderlich, weil durch die Kopplung der Kollektoranschlüsse von T119 mit T123 sowie T120 mit T124 jeweils zwei Stromquellen gegeneinandergeschaltet werden. Damit das Potential der Kopplungspunkte nicht zu sehr aus der Symmetrielage abweicht, regelt der Hilfsregelkreis den Strom in T112 derart, daß die mittlere Gleichspannung am Basisanschluß von T121 dem Wert am Basisanschluß von T122 entspricht. Dieser Potentialwert ist wie oben beschrieben als Referenzwert eingestellt. Damit wird verhindert, daß bei keinem der Transistoren T119, T120, T123 und T124 durch Verschiebung des Potentials in den Kopplungspunkten die Kollektor-Emitter-Spannung unter 0,3V fällt und der entsprechende Transistor somit in den Sättigungsbetrieb gerät.

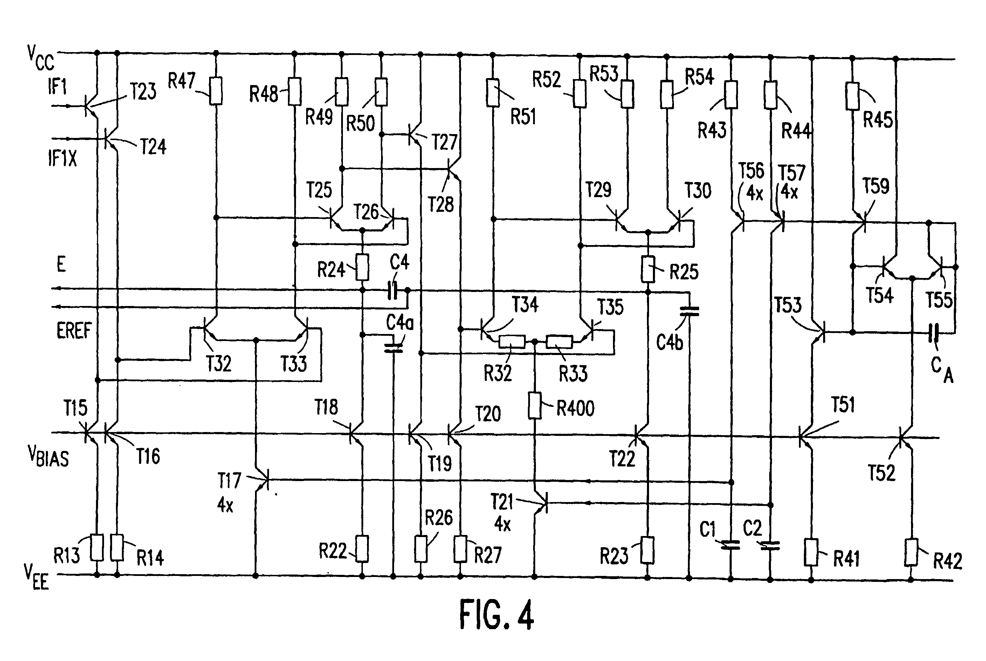

Eine schaltungstechnische Realisierung des Sensors 3 des Ausführungsbeispiels der erfindungsgemäßen Hochfrequenzpegelregelung ist in der Figur 4 angegeben. Die Amplitude des Zwischenfrequenzsignals IF1 bzw. invertierten Zwischenfrequenzsignals IF1X ist zu messen und mit einem Referenzsignal zu vergleichen. Dazu wird im Sensor 3 ein Meßsignal E und ein Referenzsignal EREF in Abhängigkeit von IF1/IF1X erzeugt. Das Signal IF1/IF1X liegt als Eingangssignal am Basisanschluß eines Emitterfolgers aus einem npn-Transistor T23 bzw. T24, dessen Kollektoranschluß jeweils mit der Versorgungsspannung V_{CC} gekoppelt sind. Der Emitteranschluß von T23 ist mit dem Kollektoranschluß eines npn-Transistors T15 verbunden, dessen Basisanschluß an der Referenzspannungsquelle V_{BIAS} angeschlossen ist. Der Emitteranschluß dieses als Konstantstromquelle arbeitenden Transistors T15 ist über einen Widerstand R13 mit der Bezugsspannung V_{EE} gekoppelt. Entsprechend liefern in einem symmetrischen Schaltungsteil ein npn-Transistor T16 und ein Widerstand R14 einen konstanten Strom für den Emitteranschluß von T24.

Der Emitteranschluß von T23 bzw. T24 ist außerdem mit dem Basisanschluß eines npn-Transistors T33 bzw. T32 verbunden. Die Transistoren T32 und T33 bilden eine Vorverstärkerstufe, wobei die Kollektoranschlüsse sowohl über Widerstände R47 bzw. R48 mit V_{CC} als auch mit den Basisanschlüssen von npn-Transistoren T25 und T26 verbunden sind. Die Emitteranschlüsse von T32 und T33 sind beide mit dem Kollektoranschluß eines npn-Transistors T17 gekoppelt, dessen Emitteranschluß mit V_{EE} verbunden ist. T25 und T26 bilden eine zweite Stufe des Istwert-Verstärkers, wobei ihre Kollektoranschlüsse über Widerstände R49 bzw. R50 mit V_{CC} gekoppelt sind. Die Emitteranschlüsse von T25 und T26 sind gemeinsam mit dem ersten Anschluß eines Widerstandes R24 gekoppelt. Am zweiten Anschluß von R24 wird das Meßsignal E ausgekoppelt und dem Regelverstärker 2 zugeführt. Dieser Anschluß von R24 ist noch mit dem Kollektoranschluß eines npn-Transistors T18 verbunden, der einen konstanten Strom liefert. Dazu ist der Basisanschluß von T18 mit V_{BIAS} und der Emitteranschluß über einen Widerstand R22 mit V_{EE} gekoppelt. Parallel zu der Reihenschaltung aus T18 und R22 ist ein Kondenator C4a geschaltet.

Der Kollektoranschluß von T25 bzw. T26 ist außerdem mit dem Basisanschluß eines npn-Transistors T28 bzw. T27 verbunden. Die Kollektoranschlüsse von T27 und T28 liegen an V_{CC}. Der Emitteranschluß von T27 ist mit dem Kollektoranschluß eines npn-Transistors T19 gekoppelt. Der Basisanschluß von T19 ist mit V_{BIAS} verbunden und der Emitteranschluß über einen Widerstand R26 mit V_{EE} gekoppelt. Entsprechend ist ein npn-Transistor T20 und ein Widerstand R27 mit dem Emitteranschluß von T28 gekoppelt. Der Kollektoranschluß von T27 bzw. T28 ist noch mit dem Basisanschluß eines npn-Transistors T35 bzw. T34 verbunden. Der Kollektoranschluß von T34 liegt über einen Widerstand R51, und der Kollektoranschluß von T35 über einen Widerstand R52 an V_{CC}. Der Emitteranschluß von T34 bzw. T35 ist mit dem ersten Anschluß eines Widerstandes R32 bzw. R33 verbunden, dessen zweiter Anschluß mit dem ersten Anschluß eines Widerstandes R400 gekoppelt ist. Anstelle der zwei Widerstände R32 und R33 kann auch ein Widerstand verwendet werden, der an seinen zwei Anschlüssen mit T34 und T35 und an einer Mittelanzapfung mit dem ersten Anschluß von R400 verbunden ist. Der zweite Anschluß von R400 ist mit dem Kollektoranschluß eines npn-Transistors T21 gekoppelt, dessen Emitteranschluß mit V_{EE} verbunden ist. Der Kollektoranschluß von T34 ist noch mit dem Basisanschluß eines npn-Transistors T29 und der Kollektoranschluß von T35 noch mit dem Basisanschluß eines npn-Transistors T30 verbunden. Der Kollektoranschluß von T29 bzw. T30 liegt über einen Widerstand R53 bzw. R54 an V_{CC}. Die Emitteranschlüsse von T29 und T30 sind beide mit dem ersten Anschluß eines Widerstandes R25 verbunden, an dessen zweitem Anschluß das Referenzsignal EREF abgegriffen wird. Dieser Anschluß ist außerdem mit dem Kollektoranschluß eines npn-Transistors T22 und über einen Kondensator C4 mit dem zweiten Anschluß von R24 gekoppelt. Der Basisanschluß von T22 liegt an V_{BIAS} und der Emitteranschluß über einen Widerstand R23 an V_{EE}. Parallel zu der Reihenschaltung aus T22 und R23 ist ein Kondensator C4b geschaltet.

Die Basisanschlüsse der als Konstantstromquellen arbeitenden Transistoren T17 und T21 sind nicht direkt mit V_{BIAS} gekoppelt. Der Basisstrom wird mittels eines npn-Transistors T53 von einem Schaltungsteil geliefert, der im folgenden beschrieben wird. Dabei ist der Basisanschluß eines npn-Transistors T51 mit V_{BIAS} verbunden. Der Emitteranschluß von T51 liegt über einen Widerstand R41 an V_{EE}, während der Kollektoranschluß bei dieser Verschaltung einen konstanten Strom für den Emitteranschluß von T53 liefert. Der Kollektoranschluß von T53 ist mit V_{CC} verbunden. Auf diese Weise entsteht an ein konstanter Basisstrom an T53, der als Referenz für T17 und T21 verwendet wird. Dieser Strom wird über einen Stromspiegel aus pnp-Transistoren T59, T57 und T56, der durch npn-Transistoren T54 und T55 geregelt sowie durch einem Kondensator C_{A} stabilisiert wird, in die Basisanschlüsse von T17 und T21 hineingespiegelt. Dazu ist der Basisanschluß von T53 mit dem Kollektoranschluß von T59 verbunden, der die Primärseite des Stromspiegels bildet. Weiterhin ist dieser Basisanschluß noch mit dem Basisanschluß von T54 und über C_{A} mit dem Basisanschluß von T55 gekoppelt. Der Emitteranschluß von T59 ist über einen Widerstand R45 mit V_{CC} und der Basisanschluß mit den Basisanschlüssen der parallel geschalteten T56 und T57 verbunden, die die Sekundärseite des Stromspiegels bilden. Der Emitteranschluß von T56 ist über einen Widerstand R43 mit V_{CC} und der Kollektoranschluß mit dem Basisanschluß von T17 verbunden. Entsprechend ist der Emitteranschluß von T57 über einen Widerstand R44 mit V_{CC} und der Kollektoranschluß mit dem Basisanschluß von T21 gekoppelt. Die Kollekttoranschlüsse von T56 und T57 sind noch über je einen Glättungskondensator C1 bzw. C2 mit V_{EE} verbunden.

Der Kollektoranschluß von T55 ist mit dem Basisanschluß von T59 und mit seinem Basisanschluß gekoppelt, während der Kollektoranschluß von T54 mit V_{CC} verbunden ist. Die Emitteranschlüsse von T54 und T55 sind mit dem Kollektoranschluß eines npn-Transistors T52 gekoppelt. Der Basisanschluß von T52 liegt an V_{BIAS} und der Emitteranschluß über einen Widerstand R42 an V_{EE}.

Auf diese Weise wird der Stromverbrauch reduziert, und es kann eine geringere Versorgungsspannung V_{CC} verwendet werden. Der Stromspiegel für den Basisstrom des Referenztransistors T53 besitzt zur Stromeinsparung bestimmte Übersetzungsfaktoren. Die Regelung des Stromspiegels durch T54 und T55 ist aus Figur 2 bekannt. Der Widerstand R400 stellt für die beiden Kollektoren von T17 und T21 die gleiche Spannung ein, wodurch sich die Symmetrie der beiden Stromquellen verbessert.

Der Sensor 3 kann somit in drei wesentliche Schaltungsteile aufgeteilt werden. Der Meßpfad zur Bildung eines Meßwertes E aus dem zugeführten Zwischenfrequenzsignal IF1/IF1X wird aus dem Emitterfolger T23/T24 gebildet. Danach liegt das Signal am Eingang des Istwert-Verstärkers aus Vorverstärkerstufe T32/T33 und zweiter Stufe T25/T26. Die Vorverstärkerstufe arbeitet linear, während der Pegel am Eingang der zweiten Stufe meist ausreichend groß ist, so daß T25 und T26 aufgrund der Übersteuerung im Schalterbetrieb arbeiten. Die Spannung an den Emitteranschlüssen einer solchen Differenzstufe besitzt in der Ruhelage (sog. Symmetrielage) einen definierten Wert und steigt davon ausgehend zweimal pro Periode des Sinus des Hochfrequenzsignals an. Durch eine Tiefpaßfilterung mittels R24 und C4 wird ein Meßsignal E gebildet.

Dieser Meßpfad aus T23/T24, T32/T33, T25/T26 und R24 wird mit T27/T28, T34/T35, T29/T30 und R25 noch einmal als Referenzpfad nachgebildet. Damit wird nicht nur eine DC-Referenz erzeugt, sondern der Referenzpfad verarbeitet ein hochfrequentes Signal, das durch Amplitudenbegrenzung direkt aus dem Meßpfad abgegriffen wird. Da T25/T26 aufgrund der Übersteuerung im Schalterbetrieb arbeiten, ist der Spannungsabfall an R49 und R50 nur abhängig von dem Strom, der von der Konstantstromquelle T18 geliefert wird. Dieser Spannungsabfall bestimmt den Eingangspegel für die Verstärkung im Referenzpfad, der das Referenzsignal EREF erzeugt. Dieser Strom ist so eingestellt, daß das Referenzsignal EREF den Pegel annimmt, auf den das Zwischenfrequenzsignal IF1/IF1X im Regelkreis nach Figur 1 geregelt werden soll. Der Vorteil dieser schaltungstechnischen Realisierung mit zwei korrelierten Pfaden im Sensor 3 liegt in der Kompensation der Temperaturgänge und der Frequenzabhängigkeiten von Meßsignal E und Referenzsignal EREF. Dies erlaubt eine frequenzunabhängige Pegelregelung für das Zwischenfrequenzsignal IF1/IF1X.

Der Unterschied zwischen beiden Pfaden liegt darin, daß das Meßsignal E einen sinusförmigen Verlauf hat, während das Referenzsignal EREF idealerweise einen rechteckförmigen Verlauf besitzt, da aufgrund der Übersteuerung insbesodere die Transistoren T34/T35 im Schalterbetrieb arbeiten. Da dies zu Fehlern in Regelung führen würde, sind zur Anpassung die Emitterwiderstände R32 und R33 vorgesehen, die den rechteckförmigen Signalverlauf verschleifen. Weiterhin kann noch durch Variieren des Wertes für R47 und R48 der Spannungsabfall über den Widerständen und damit der Eingangspegel für die zweite Stufe (T25/T26) des Istwert-Verstärkers eingestellt werden. Dadurch wird der Arbeitspunkt der Transistoren (linearer Bereich oder Sättigungsbereich) und folglich auch die Form des Meßsignals E bestimmt. Bei geeigneter Einstellung dieser Variationsmöglichkeiten können die Pfade für die beiden Signale im Sensor 3 so angepaßt werden, daß sich die Amplituden-Ortskurven von E und EREF über dem Ausgangssignal des Regelkreises A_{OUT} temperaturunabhängig in einem gewählten Schnittpunkt schneiden. Das Zwischenfrequenzsignal IF1/IF1X bildet das Ausgangssignal A_{OUT} des Regelkreises, das als Eingangssignal des Sensors 3 dem Meß- und Referenzpfad zugeführt wird. Wenn der Pegel von IF1/IF1X beispielsweise auf einen Wert von 50 mV geregelt werden soll, muß IF1/IF1X in beiden Pfaden auf die gleiche Amplitude für E und EREF verstärkt werden. Dadurch verschwindet die dem gekoppelten Regelverstärker 2 als Eingangssiganl zugeführte Differenz aus Meß- und Referenzsignal (E-EREF = 0). Diese Eigenschaften des Sensors verändern sich nicht mit den Toleranzen von integrierten Widerständen und Kondensatoren. Des weiteren hat auch die DC-Offset-Spannung zwischen IF1 und IF1X einen sehr geringen Einfluß.

Der Sensor 3 enthält mit den Elementen R24, R25, C4, C4a und C4b noch einen Tiefpaß, der verhindert, daß der Regelverstärker 2 durch das HF-Signal zu weit ausgesteuert wird.

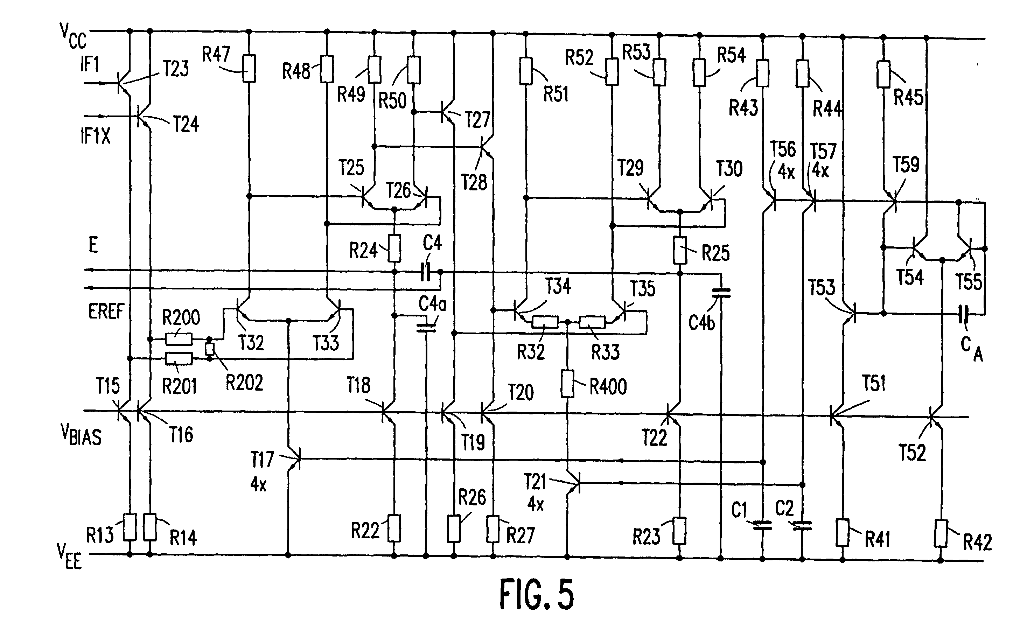

Eine weitere schaltungstechnische Realisierung des Sensors 3 des Ausführungsbeispiels für die erfindungsgemäße Hochfrequenzpegelregelung ist in der Figur 5 angegeben. Hier ist in Abweichung von Figur 4 ein Spannungsteiler aus Widerständen R200, R201 und R202 derart eingefügt, daß nur ein Teil des zu messenden Zwischenfrequenzsignals an den Basisanschlüssen von T32 und T33 anliegt. Durch geeignete Wahl der Widerstände R200, R201 und R202 kann die Amplitude des Eingangssignals des Sensors 3 auf diese Weise auf einen wählbaren Wert eingestellt werden. Vorteilhafterweise sind die einzelnen Widerstände teilbar, so daß geeignete Spannungsteilungsverhältnisse einstellbar sind. Dadurch kann der Sensor 3 für einen großen Bereich von Eingangssignalamplituden betrieben werden, ohne daß weitere Elemente verändert werden müssen.

## Patentansprüche

1. Schaltungsanordnung zur Hochfrequenzpegelregelung mit
- einem Pegelstellglied (1) zur Bildung eines Ausgangssignals (A_{OUT}) mittels Mischung eines Eingangssignals (A_{IN}) und eines Rückkopplungssignals (S/SX) in einer Gilbert-Zelle,
- einem Sensor (3) in einem Rückkopplungszweig zur Bildung eines Meßsignals (E) und eines Referenzsignals (EREF) aus dem Ausgangssignal (A_{OUT}) und
- einem Regelverstärker (2) im Rückkopplungszweig zur Bildung des Rückkopplungssignals (S/SX) aus der Differenz zwischen Meß- und Referenzsignal (E-EREF),
**dadurch gekennzeichnet,**
**daß** in der Gilbert-Zelle zwischen einer mit dem Rückkopplungssignal (S/SX) gekoppelten ersten Stufe (T117, T118) und einer mit dem Eingangssignal (A_{IN}) gekoppelten zweiten Stufe (T11, T12, T13, T14, R17, R18) wenigstens eine Stromspiegelanordnung (T100, T101, T5, T6, T7 bzw. T102, T103, T8, T9, T10) vorgesehen ist.

2. Schaltungsanordnung nach Anspruch 1,
**dadurch gekennzeichnet,**
**daß** die Stromspiegelanordnung (T100, T101, T5, T6, T7 bzw. T102, T103, T8, T9, T10) aus wenigstens zwei in Serie geschalteten symmetrischen Stromspiegeln besteht.

3. Schaltungsanordnung nach Anspruch 2,
**dadurch gekennzeichnet,**
**daß** in der Stromspiegelanordnung (T100, T101, T5, T6, T7 bzw. T102, T103, T8, T9, T10) ein erster Stromspiegel bestehend aus wenigstens zwei pnp-Bipolartransistoren (T100, T101 bzw. T102, T103) und ein zweiter Stromspiegel bestehend aus wenigstens zwei npn-Bipolartransistoren (T5, T6, T7 bzw. T8, T9, T10) vorgesehen ist.

4. Schaltungsanordnung nach Anspruch 3,
**dadurch gekennzeichnet,**
**daß** zur Regelung des ersten Stromspiegels (T100, T101 bzw. T102, T103)
- ein Kollektoranschluß und ein Basisanschluß eines ersten Regeltransistors (T104 bzw. T106) zur Kopplung mit dem Eingangssignal des Stromspiegels und ein Emitteranschluß des ersten Regeltransistors (T104 bzw. T106) zur Kopplung mit einer konstanten Stromquelle (T108 bzw. T109) und
- ein Basisanschluß eines zweiten Regeltransistors (T105 bzw. T107) zur Kopplung mit dem Eingangssignal, ein Kollektoranschluß des zweiten Regeltransistors (T105 bzw. T107) zur Kopplung mit einer Versorgungsspannung (V_{CC}) und ein Emitteranschluß des zweiten Regeltransistors (T105 bzw. T107) zur Kopplung mit der konstanten Stromquelle (T108 bzw. 109)
vorgesehen ist.

5. Schaltungsanordnung nach einem der Ansprüche 1 bis 4,
**dadurch gekennzeichnet,**
**daß** im Sensor 3 ein mittels eines Spannungsteilers erzeugter Teil des Ausgangssignals (A_{OUT}) zur Bildung des Meßsignals (E) und des Referenzsignals (EREF) vorgesehen ist.

6. Mobilfünkgerät mit einer Schaltungsanordnung zur Hochfrequenzpegelregelung mit
- einem Pegelstellglied (1) zur Bildung eines Ausgangssignals (A_{OUT}) mittels Mischung eines Eingangssignals (A_{IN}) und eines Rückkopplungssignals (S/SX) in einer Gilbert-Zelle,
- einem Sensor (3) in einem Rückkopplungszweig zur Bildung eines Meßsignals (E) und eines Referenzsignals (EREF) aus dem Ausgangssignal (A_{OUT}) und
- einem Regelverstärker (2) im Rückkopplungszweig zur Bildung des Rückkopplungssignals (S/SX) aus der Differenz zwischen Meß- und Referenzsignal (E-EREF),
**dadurch gekennzeichnet,**
**daß** in der Gilbert-Zelle zwischen einer mit dem Rückkopplungssignal (S/SX) gekoppelten ersten Stufe (T117, T118) und einer mit dem Eingangssignal (A_{IN}) gekoppelten zweiten Stufe (T11, T12, T13, T14, R17, R18) wenigstens eine Stromspiegelanordnung (T100, T101, T5, T6, T7 bzw. T102, T103, T8, T9, T10) vorgesehen ist.

## Claims

1. A circuit arrangement for radio frequency level control, comprising
- a level controller (1) for forming an output signal (A_{OUT}) by mixing an input signal (A_{IN}) and a feedback signal (S/SX) in a Gilbert cell,
- a sensor (3) in a feedback path for producing a measuring signal (E) and a reference signal (EREF) from the output signal (A_{OUT}), and
- a variable gain amplifier (2) in the feedback path for producing the feedback signal (S/SX) from the difference between measuring signal and reference signal (E-EREF), **characterized in that** at least one current mirror circuit (T100, T101, T5, T6, T7; T102, T103, T8, T9, T10, respectively) is provided in the Gilbert cell between a first stage (T117, T118) coupled to the feedback signal (S/SX) and a second stage (T11, T12, T13, T14, R17, R18) coupled to the input signal (A_{IN}).

2. A circuit arrangement as claimed in claim 1, **characterized in that** the current mirror circuit (T100, T101, T5, T6, T7; T102, T103, T8, T9, T10, respectively) comprises at least two series-connected symmetrical current mirrors.

3. A circuit arrangement as claimed in claim 2, **characterized in that** the current mirror circuit (T100, T101, T5, T6, T7; T102, T103, T8, T9, T10, respectively) comprises a first current mirror formed by at least two pnp bipolar transistors (T100, T101; T102, T103, respectively) and a second current mirror formed by at least two npn bipolar transistors (T5, T6, T7; T8, T9, T10, respectively).

4. A circuit arrangement as claimed in claim 3, **characterized in that** for controlling the first current mirror (T100, T101; T102, T103, respectively),
- a collector terminal and a base terminal of a first control transistor (T104; T106, respectively) are coupled to the input signal of the current mirror, and an emitter terminal of the first control transistor (T104; T106, respectively) is coupled to a constant power source (T108; T109, respectively), and
- a base terminal of a second control transistor (T105; T107, respectively) is coupled to the input signal, a collector terminal of the second control transistor (T105; T107, respectively) is coupled to a supply voltage (V_{CC}) and an emitter terminal of the second control transistor (T105; T107, respectively) is coupled to the constant power source (T108; T109, respectively).

5. A circuit arrangement as claimed in one of the claims 1 to 4, **characterized in that** in the sensor (3) a part of the output signal (A_{OUT}) produced by a voltage divider is used for forming the measuring signal (E) and the reference signal (EREF).

6. A mobile radio device comprising a circuit arrangement for radio frequency level control, comprising
- a level controller (1) for forming an output signal (A_{OUT}) by mixing an input signal (A_{IN}) and a feedback signal (S/SX) in a Gilbert cell,
- a sensor (3) in a feedback path for producing a measuring signal (E) and a reference signal (EREF) from the output signal (A_{OUT}), and
- a variable gain amplifier (2) in the feedback path for producing the feedback signal (S/SX) from the difference between measuring signal and reference signal (E-EREF), **characterized in that** at least one current mirror circuit (T100, T101, T5, T6, T7; T102, T103, T8, T9, T10, respectively) is provided in the Gilbert cell between a first stage (T117, T118) coupled to the feedback signal (S/SX) and a second stage (T11, T12, T13, T14, R17, R18) coupled to the input signal (A_{IN}).

## Revendications

1. Circuit pour le réglage de niveau à haute fréquence avec
- un organe de réglage de niveau (1) pour la formation d'un signal de sortie (A_{OUT}) à l'aide du mélange d'un signal d'entrée (A_{IN}) et d'un signal de rétroaction (S/SX) dans une cellule de Gilbert,
- un capteur (3) dans une branche de rétroaction pour la formation d'un signal de mesure (E) et d'une signal de référence (EREF) partir du signal d'entrée (E_{OUT}) et
- un amplificateur de réglage (2) dans la branche de rétroaction pour la formation du signal de rétroaction (S/SX) à partir de la différence entre le signal de mesure et de référence (E-EREF), **caractérisé en ce qu'**au moins un dispositif miroir de courant (T100, T101, T5, T6, T7 ou T102, T103, T8, T9, T10) est prévu dans la cellule de Gilbert entre un premier étage (T117, T118) couplé au signal de rétroaction (S/SX) et un deuxième étage (T11, T12, T13, T14, R17, R18) couplé au signal d'entrée (A_{IN}).

2. Circuit selon la revendication 1, **caractérisé en ce que** le dispositif miroir de courant (T100, T101, T5, T6, T7 ou T102, T103, T8, T9, T10) se compose d'au moins deux miroirs de courant symétriques montés en série.

3. Circuit selon la revendication 1, **caractérisé en ce que** le dispositif miroir de courant (T100, T101, T5, T6, T7 ou T102, T103, T8, T9, T10) comprend au moins un premier miroir de courant composé d'au moins deux transistors bipolaires pnp (T100, T101 ou T102, T103) et un deuxième miroir de courant composé d'au moins deux transistors bipolaires npn (T5, T6, T7 ou T8, T9, T10).

4. Circuit selon la revendication 3, **caractérisé en ce que**, pour le réglage du premier niveau de courant (T100, T101 ou T102, T103), il est prévu :
- une borne de collecteur et une borne de base d'un premier transistor de réglage (T104 ou T106) pour le couplage avec le signal d'entrée du miroir de courant et une borne d'émetteur du premier transistor de réglage (T104 ou T106) pour le couplage avec une source de courant constante (T108 ou T109) et
- une borne de base d'un deuxième transistor de réglage (T105 ou T107) pour le couplage avec le signal d'entrée, une borne de collecteur du deuxième transistor de réglage (T105 ou T107) pour le couplage avec une tension d'alimentation (V_{CC}) et une borne d'émetteur du deuxième transistor de réglage (T105 ou T107) pour le couplage avec la source de courant constant (T108 ou T109).

5. Circuit selon l'une des revendications 1 à 4, **caractérisé en ce que**, dans le capteur 3, une partie du signal de sortie (A_{OUT}) produite à l'aide d'un diviseur de tension est prévue pour la formation du signal de mesure (E) et du signal de référence (EREF).

6. Appareil radiomobile avec un circuit pour le réglage de niveau à haute fréquence avec
- un organe de réglage de niveau (1) pour la formation d'un signal de sortie (A_{OUT}) à l'aide du mélange d'un signal d'entrée (A_{IN}) et d'un signal de rétroaction (S/SX) dans une cellule de Gilbert,
- un capteur (3) dans une branche de rétroaction pour la formation d'un signal de mesure (E) et d'une signal de référence (EREF) partir du signal d'entrée (E_{OUT}) et
- un amplificateur de réglage (2) dans la branche de rétroaction pour la formation du signal de rétroaction (S/SX) à partir de la différence entre le signal de mesure et de référence (E-EREF), **caractérisé en ce qu'**au moins un dispositif miroir de courant (T100, T101, T5, T6, T7 ou T102, T103, T8, T9, T10) est prévu dans la cellule de Gilbert entre un premier étage (T117, T118) couplé au signal de rétroaction (S/SX) et un deuxième étage (T11, T12, T13, T14, R17, R18) couplé au signal d'entrée (A_{IN}).
